# EUROPEAN PATENT APPLICATION

(11) **EP 4 485 618 A1**
(43) Date of publication of application: **01.01.2025**
(21) Application number: 23760424.4
(22) Date of filing: 24.02.2023
(51) Int. Cl.: H01M 10/48, H01M 10/42, H01M 50/519, H01M 50/569, H01M 50/105, H05K 1/14

(54) **FLEXIBLE PRINTED CIRCUIT BOARD AND SECONDARY BATTERY MODULE COMPRISING SAME**

(30) Priority: 24.02.2022 KR 20220024705
(71) Applicant: LG Energy Solution, Ltd., Seoul 07335 (KR)
(72) Inventor: LEE, Won Tae, Daejeon 34122 (KR); LEE, Chang Bok, Daejeon 34122 (KR); OH, Kyu Hwan, Daejeon 34122 (KR); HWANG, Sung Tack, Daejeon 34122 (KR)
(74) Representative: Goddar, Heinz J.
(86) International application number: PCT/KR2023/002679
(87) International publication number: WO 2023/163550

(57) **Abstract**

The present invention has been devised to solve the problems as above and an object of the present invention is to provide a flexible printed circuit board, which is capable of detecting and continuously monitoring it through a simple structure change whether a secondary battery module is submerged or an electrolyte of a pouch cell leaks in the secondary battery module, so that quality and safety of the battery is secured and also space utilization and energy density in the module is maximized, and a secondary battery module including the flexible printed circuit.

A secondary battery module according to Embodiment 1 of the present invention includes a pouch cell assembly, in which a plurality of pouch cells are arranged in a thickness direction, a busbar frame assembly, which is coupled to each of one side and the other side of the pouch cell assembly, and a flexible printed circuit board which is coupled to the busbar frame assembly and in which a film layer is stacked on at least one surface of a metal layer. The flexible printed circuit board includes a body part, which is provided between the busbar frame assemblies coupled to the one side and the other side of the pouch cell assembly, respectively, and a sensing part which extends from the body part, wherein the sensing part extends from at least one of one side or the other side in a longitudinal direction of the body part, and is provided at each of one side and the other side in a width direction of the body part to sense leakage of moisture or an electrolyte.

## Description

### TECHNICAL FIELD

The present application claims the benefit of the priority of Korean Patent Application No. 10-2022-0024705, filed on February 24, 2022, which is hereby incorporated by reference in its entirety.

The present invention relates to a flexible printed circuit board and a secondary battery module including the same, and more particularly, to a flexible printed circuit board, which is capable of detecting and continuously monitoring whether a secondary battery module is submerged or an electrolyte of a pouch cell leaks in the secondary battery module, and a secondary battery module including the flexible printed circuit.

### BACKGROUND ART

Secondary batteries refer to batteries that are chargeable and dischargeable unlike non-rechargeable primary batteries, and types of the secondary batteries include a nickel-cadmium battery, a nickel-hydrogen battery, a lithium-ion battery, a lithium-ion polymer battery, and the like. These secondary batteries are applied to and used in not only small products such as digital camera, notebook computer, mobile phone, PDA and E-bike, but also large products, such as electric vehicle and hybrid vehicle, which require higher powers, energy storage systems for storing surplus electricity or new renewable energy, and energy storage systems for backup.

These secondary batteries are classified into a pouch type, a can type, and the like, according to a material of a battery case that accommodates an electrode assembly. In the pouch type, the electrode assembly is accommodated in a pouch made of a flexible polymer material having a variable shape. In the can type, the electrode assembly is accommodated in a case made of a material such as metal or plastic, which has a fixed shape.

The secondary batteries may be configured as a cell, a module, or a pack according to a gathering unit of the secondary batteries. First, the cell is a radical unit of a secondary battery, which is capable of being used by charging and discharging electrical energy, and may be the pouch type secondary battery, the can type secondary battery, or the like, which are described above.

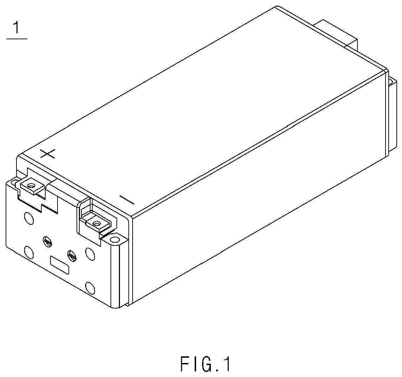

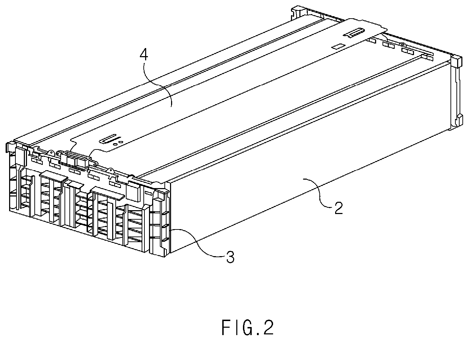

FIG. 1 is a perspective view illustrating a secondary battery module according to the related art. FIG. 2 is a perspective view illustrating main components of a secondary battery module according to the related art. Referring to FIGS. 1 and 2, a module 1 means a unit assembly in which cells are bundled in a fixed number, or a predetermined number of cell assemblies 2 are provided and then, accommodated in a frame to protect the cells from an external impact, heat, vibration, or the like, as illustrated in FIG. 1. In particular, the module may include, in addition to the cell assemblies 2, a fixing plate 3 (or busbar frame assembly) on which a busbar that electrically connects the cell assemblies is seated and which fixes a pouch cell assembly, a circuit board 4 which measures a cell voltage, temperature, or the like in the module to transmit the same to the outside, and so on.

In addition, the pack is a final form of a battery system and completed by mounting various control and protection systems such as BMS and cooling system, on the secondary battery module.

In a pouch type cell, an electrolyte injected into the cell may leak in the module due to a sealing defect of the pouch, damage to the pouch, or the like. In this case, corrosion of the pouch may occur, and the corrosion may lead to performance degradation of the battery or fire of a vehicle so that quality reliability of products is reduced and user's safety is seriously threatened.

Thus, there is a need to check it during a manufacturing process whether the electrolyte of the cell leaks in the completely assembled module, and there is a need to continuously monitor the module or pack also in a field after the module or pack is assembled with the vehicle, to secure the safety.

### DISCLOSURE OF THE INVENTION

### TECHNICAL PROBLEM

The present invention has been devised to solve the problems as above and an object of the present invention is to provide a flexible printed circuit board, which is capable of detecting and continuously monitoring it through a simple structure change whether a secondary battery module is submerged or an electrolyte of a pouch cell leaks in the secondary battery module, so that quality and safety of the battery is secured and also space utilization and energy density in the module is maximized, and a secondary battery module including the flexible printed circuit.

### TECHNICAL SOLUTION

A secondary battery module according to Embodiment 1 of the present invention includes a pouch cell assembly, in which a plurality of pouch cells are arranged in a thickness direction, a busbar frame assembly, which is coupled to each of one side and the other side of the pouch cell assembly, and a flexible printed circuit board (FPCB) which is coupled to the busbar frame assembly and in which a film layer is stacked on at least one surface of a metal layer. The flexible printed circuit board includes a body part, which is provided between the busbar frame assemblies coupled to the one side and the other side of the pouch cell assembly, respectively, and a sensing part extending from the body part, wherein the sensing part extends from at least one of one side or the other side in a longitudinal direction of the body part and is provided at each of one side and the other side in a width direction of the body part to sense leakage of moisture or an electrolyte.

The sensing part may include a first extension line part, which extends toward the one side in the width direction of the body part, and a second extension line part which extends toward the other side in the width direction of the body part.

Each of the first extension line part and the second extension line part may be bent along a circumference of the busbar frame assembly.

The first extension line part and the second extension line part may have ends, respectively, which are bent to face each other in a state of being spaced a predetermined gap from each other.

The first extension line part may have an end having a first exposed portion at which the metal layer is exposed, and the second extension line part may have an end having a second exposed portion at which the metal layer is exposed.

The sensing part may sense whether the first exposed portion and the second exposed portion are electrically connected to each other by the moisture or electrolyte.

The busbar frame assembly may include a busbar, which is electrically coupled to an electrode lead of the pouch assembly, and a fixing plate in which a lead insertion part having a slit having a shape passing through front and rear surfaces so that the electrode lead is inserted thereinto, a busbar seating part provided at one side of the lead insertion part, and a terrace part extending from a lower portion of the lead insertion part to a side of the pouch cell assembly, are provided. The first exposed portion and the second exposed portion may be disposed on a top surface of the terrace part.

The busbar frame assembly may further include a cover plate that covers the busbar and is coupled to the fixing plate.

The secondary battery module may further include a module case, which has both ends opened and in which the pouch cell assembly and the busbar frame assembly are accommodated, and an end plate which covers each of both the opened ends of the module case.

The secondary battery module may further include a connector that transmits a signal output from the flexible printed circuit board to an external battery management system (BMS) .

A terrace part of a secondary battery module according to Embodiment 2 of the present invention may include a first inclined part having a height that gradually decreases from one side to a center, and a second inclined part having a height that gradually decreases from the other side to the center, wherein the first exposed portion is disposed on a top surface of the first inclined part, and the second exposed portion is disposed on a top surface of the second inclined part.

A flexible printed circuit board according to Embodiment 2 of the present invention is a flexible printed circuit board (FPCB) in which a film layer is stacked on at least one surface of a metal layer. The flexible printed circuit board includes a body part and a sensing part which extends from the body part and is provided at each of one side and the other side in a width direction of the body part to sense leakage of moisture or an electrolyte, at least one of one side or the other side in a longitudinal direction of the body part.

The sensing part may include a first extension line part, which extends toward the one side in the width direction of the body part, and a second extension line part, which extends toward the other side in the width direction of the body part.

The first extension line part may extend toward the one side in the width direction of the body part and have an area of at least a portion including an end, which is provided to be parallel to the longitudinal direction of the body part. The second extension line part may extend toward the other side in the width direction of body part and have an area of at least a portion including an end, which is provided to be parallel to the longitudinal direction of the body part.

Each of the first extension line part and the second extension line part may be provided to be bendable.

The first extension line part may have an end having a first exposed portion at which the metal layer is exposed, and the second extension line part may have an end having a second exposed portion at which the metal layer is exposed.

The sensing part may sense whether the first exposed portion and the second exposed portion are electrically connected to each other by the moisture or electrolyte.

### ADVANTAGEOUS EFFECTS

The secondary battery module according to the present invention includes the pouch cell assembly, in which the plurality of pouch cells are arranged in the thickness direction, the busbar frame assembly, which is coupled to each of the one side and the other side of the pouch cell assembly, and the flexible printed circuit board (FPCB) which is coupled to the busbar frame assembly and in which the film layer is stacked on the at least one surface of the metal layer. The flexible printed circuit board includes the body part, which is provided between the busbar frame assemblies coupled to the one side and the other side of the pouch cell assembly, respectively, and the sensing part, which extends from the body part, extending from the at least one of the one side or the other side in the longitudinal direction of the body part and provided at each of the one side and the other side in the width direction of the body part to sense the moisture or the leakage of the electrolyte. Through this simple structure change, it may be detected and continuously monitored whether the secondary battery module is submerged or the electrolyte of the pouch cell leaks in the secondary battery module, and the quality and safety of the battery may be secured and also the space utilization and energy density in the module may be maximized.

### BRIEF DESCRIPTION OF THE DRAWINGS

FIG. 1 is a perspective view illustrating a secondary battery module according to the related art.
FIG. 2 is a perspective view illustrating main components of a secondary battery module according to the related art.
FIG. 3 is an exploded perspective view illustrating a secondary battery module according to Embodiment 1 of the present invention.
FIG. 4 is a perspective view illustrating main components of the secondary battery module according to Embodiment 1 of the present invention.
FIG. 5 is a perspective view illustrating a flexible printed circuit board, a fixing plate, and a connector of the secondary battery module according to Embodiment 1 of the present invention.
FIG. 6a is a side view illustrating an area A in FIG. 5 when viewed from a side. FIG. 6b is a plan view illustrating the area A in FIG. 5 when viewed from above.
FIG. 7 is a perspective view illustrating a fixing plate of a secondary battery module according to Embodiment 2 of the present invention.
FIG. 8a is a side view illustrating a first extension line part, a second extension line part, and a terrace part of the secondary battery module according to Embodiment 2 of the present invention when viewed from a side. FIG. 8b is a plan view illustrating the first extension line part, the second extension line part, and the terrace part of the secondary battery module according to Embodiment 2 of the present invention when viewed from above.
FIG. 9a is a perspective view illustrating a flexible printed circuit board according to Embodiment 3 of the present invention. FIG. 9b is a perspective view illustrating a state in which a first extension line part and a second extension line part are bent in the flexible printed circuit board according to Embodiment 3 of the present invention.

### MODE FOR CARRYING OUT THE INVENTION

Hereinafter, preferred embodiments of the present invention will be described in detail with reference to the accompanying drawings to enable those skilled in the art to which the present invention pertains to easily carry out the present invention. The present invention may, however, be embodied in different forms and should not be construed as limited by the embodiments set forth herein.

The parts unrelated to the description, or the detailed descriptions of related well-known art that may unnecessarily obscure subject matters of the present invention, will be ruled out in order to clearly describe the present invention. Like reference numerals refer to like elements throughout the whole specification.

Moreover, terms or words used in this specification and claims should not be restrictively interpreted as ordinary meanings or dictionary-based meanings, but should be interpreted as meanings and concepts conforming to the scope of the present invention on the basis of the principle that an inventor can properly define the concept of a term to describe and explain his or her invention in the best ways.

### Embodiment 1

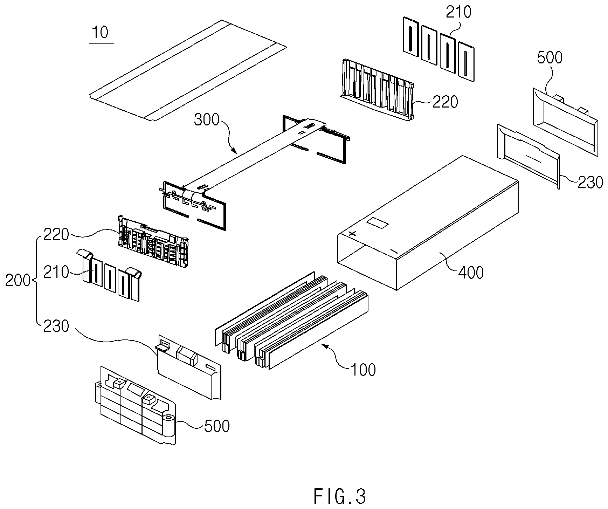

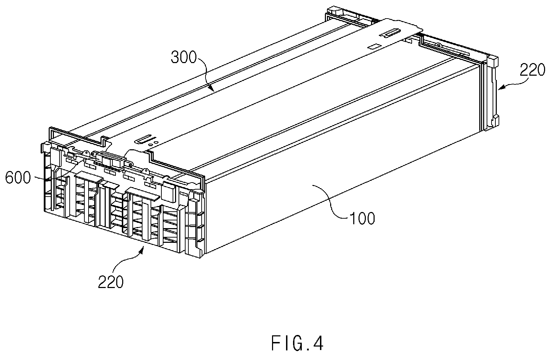

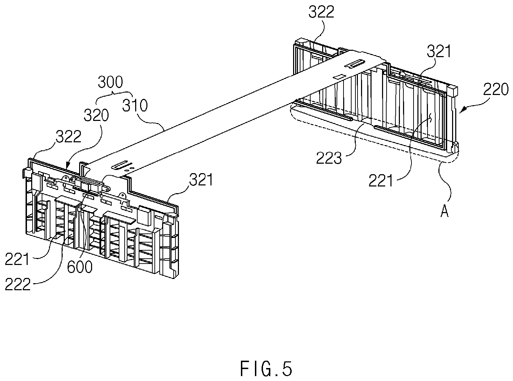

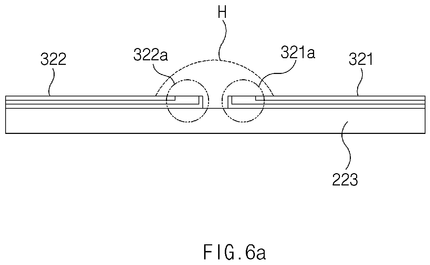

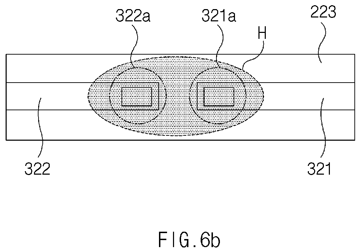

FIG. 3 is an exploded perspective view illustrating a secondary battery module according to Embodiment 1 of the present invention. FIG. 4 is a perspective view illustrating main components of the secondary battery module according to Embodiment 1 of the present invention. FIG. 5 is a perspective view illustrating a flexible printed circuit board, a fixing plate, and a connector of the secondary battery module according to Embodiment 1 of the present invention. FIG. 6a is a side view illustrating an area A in FIG. 5 when viewed from a side. FIG. 6b is a plan view illustrating the area A in FIG. 5 when viewed from above.

Referring to FIGS. 3 and 4, a secondary battery module 10 according to Embodiment 1 of the present invention includes a pouch cell assembly 100, a busbar frame assembly (BFA) 200, and a flexible printed circuit board (FPCB) 300. The pouch cell assembly 100 is provided so that a plurality of pouch cells are arranged in a thickness direction, the busbar frame assembly 200 is coupled to each of one side and the other side of the pouch cell assembly 100, the flexible printed circuit board 300 is coupled to the busbar frame assembly 200, and a film layer is stacked on at least one surface a metal layer.

In addition, the flexible printed circuit board 300 of the secondary battery module 10 according to the present invention includes a body part 310, which is provided between the busbar frame assemblies 200 coupled to the one side and the other side of the pouch cell assembly 100, respectively, and a sensing part 320, which extends from the body part 310, extending from at least one of one side or the other side in a longitudinal direction of the body part 310 and provided at each of one side and the other side in a width direction of the body part 310 to sense leakage of moisture or an electrolyte.

As above, the secondary battery module 10 according to the present invention may detect and continuously monitor whether the secondary battery module 10 is submerged or an electrolyte of a pouch cell leaks in the secondary battery module 10, through the sensing part 320 extending from the body part 310 and having a simple structure, so that quality and safety of the battery is secured. In particular, the leakage of the electrolyte be sensed by allowing the sensing part 320 to extend from the flexible printed circuit board 300, not by attaching a separate sensor to the inside of the module, so that space utilization in the module is increased and energy density of the module is maximized.

Hereinafter, each of components of the secondary battery module 10 will be described in detail.

First, referring to FIGS. 4 and 5, the sensing part 320 may include a first extension line part 321, which extends toward one side in the width direction of the body part 310, and a second extension line part 322 which extends toward the other side in the width direction of the body part 310. That is, the sensing part 320 may have two extension line parts for sensing.

Each of the first extension line part 321 and the second extension line part 322 may extend integrally from the body part 310 of the flexible printed circuit board 300. For example, the body part 310 and each of the first extension line part 321 and the second extension line part 322 may be provided by cutting the sheet-shaped flexible printed circuit board 300. Thus, in each of the first extension line part 321 and the second extension line part 322, the film layer is stacked on the at least one surface of the metal layer so as to correspond to the structure of the flexible printed circuit board 300.

Referring to FIGS. 3 and 5, each of the first extension line part 321 and the second extension line part 322 may be provided to be bendable. In particular, in the secondary battery module according to the present invention, each of the first extension line part 321 and the second extension line part 322 may be bent along a circumference of the busbar frame assembly 200. In more detail, each of the first extension line part 321 and the second extension line part 322 may be bent along an inner circumference of a fixing plate 220 of the busbar frame assembly 200. The bending shape of each of these first extension line part 321 and second extension line part 322 will be described in detail below together with the busbar frame assembly 200. As each of the first extension line part 321 and the second extension line part 322 is bent along the busbar frame assembly 200 as above, the space occupied in the module may be minimized to maximize the energy density, and the first extension line part 321 and the second extension line part 322 may be bent at an end of the pouch cell, which is an area in which leakage of the electrolyte well occurs, and on the circumference of the busbar frame assembly 200, which is in contact with the end of the pouch cell, to increase sensing sensitivity.

In the secondary battery module 10 according to Embodiment 1 of the present invention, as illustrated in FIG. 5, the first extension line part 321 and the second extension line part 322 may have ends, respectively, which are bent to face each other in a state of being spaced a predetermined gap from each other. In detail, as illustrated in FIGS. 6a and 6b, when the secondary battery module 10 is submerged or the leakage of the electrolyte occurs in the secondary battery module 10, the respective ends of the first extension line part 321 and the second extension line part 322 may be submerged together in the electrolyte or moisture H (hereinafter referred to as an electrolyte) by the electrolyte H. Here, the first extension line part 321 and the second extension line part 322 may be electrically connected to each other by the electrolyte H, and the sensing part 320 may detect the electrical connection to sense whether the leakage of the electrolyte occurs.

Thus, the predetermined gap may vary depending on the sensitivity for sensing whether the electrolyte leaks. For example, as the respective ends of the first extension line part 321 and the second extension line part 322 are closer to each other, the end of the first extension line part 321 and the end of the second extension line part 322 may be submerged together even with a small amount of the electrolyte H to be electrically connected to each other. As the respective ends of the first extension line part 321 and the second extension line part 322 are farther from each other, a large amount of the electrolyte H is required to electrically connect the ends to each other. Thus, the predetermined gap may be a gap that a designer or manufacturer designs by setting the sensitivity for sensing whether leakage of the electrolyte occurs in comprehensive consideration of the size of the module, corrosion of the battery, the amount of electrolyte leakage that may cause an occurrence of fire, or the like.

When the structure of each of the first extension line part 321 and the second extension line part 322 will continue to be described in more detail with reference to FIGS. 6a and 6b, the first extension line part 321 may have an end having a first exposed portion 321a at which a metal layer is exposed, and the second extension line part 322 may have an end having a second exposed portion 322a at which a metal layer is exposed. As described above, each of the first extension line part 321 and the second extension line part 322 extends from the flexible printed circuit board and may have a structure in which the film layer is stacked on at least one surface of the metal layer. However, each of the first exposed portion 321a and the second exposed portion 322a may be provided so that the metal layer is not blocked by the film layer and is exposed.

When the first exposed portion 321a and the second exposed portion 322a are submerged together in the electrolyte H, the first extension line part 321 and the second extension line part 322 are electrically connected to each other. As above, the sensing part 320 according to the present invention may sense the electrolyte H to determine whether the first exposed portion 321a and the second exposed portion 322a are electrically connected to each other. Thus, it is not necessary to separately provide a gas sensor that senses electrolyte vapor to detect the leakage like the related art. Only the sensing part 320 may extend from the body part 310 of the existing flexible printed circuit board 300 and the sensing part 320 may be provided with the first exposed portion 321a and the second exposed portion 322a to sense whether the electrolyte leaks, so that the safety of the battery is secured and also the space utilization in the module is increased, and the dead space is minimized to maximize the energy density of the module.

Next, the busbar frame assembly 200 will be described in detail with reference to FIGS. 3 to 5. The busbar frame assembly 200 may include a busbar 210, the fixing plate 220, and a cover plate 230.

First, the busbar 210 is made of a metal and may be electrically coupled to an electrode lead of the pouch assembly. In detail, the electrode lead may be inserted into a lead insertion part 221 of the fixing plate 220 to be described later and then, coupled to the busbar 210, which is seated on a busbar seating part 222 in advance in a bending state, by welding. In addition, the busbar 210 may be connected to each of both sides of the flexible printed circuit board 300 and accordingly, the flexible printed circuit board 300 may read the cell voltage transmitted from the electrode lead.

The fixing plate 220 may include a fixing plate 220, which is a kind of an injection-molded product and in which a lead insertion part 221 having a slit having a shape passing through front and rear surfaces so that the electrode lead is inserted thereinto, a busbar seating part 222 provided at one side of the lead insertion part 221, and a terrace part 223 extending from a lower portion of the lead insertion part 221 to a side of the pouch cell assembly 100, are provided. Here, the first exposed portion 321a and the second exposed portion 322a, which are described above, may be disposed on a top surface of the terrace part 223. In general, when the electrolyte leaks from the pouch cell, a case frequently occurs, in which the electrolyte flows around the busbar frame assembly 200 disposed at each of the both sides of the pouch assembly or the fixing plate 220 of the busbar frame assembly 200. Thus, when the first exposed portion 321a and the second exposed portion 322a for detecting the electrolyte are disposed on the top surface of the terrace part 223 of the fixing plate 220, it may be more effectively detected whether the electrolyte leaks in the module, in a state in which the first exposed portion 321a and the second exposed portion 322a, each of which has flexibility, are stably disposed.

The cover plate 230 may cover the busbar 210 seated on the busbar seating part 222 of the fixing plate 220 and be coupled to the fixing plate 220. Accordingly, the busbar 210 may be protected from an external impact or being damaged.

In addition, as illustrated in FIG. 3, the secondary battery module 10 according to the present invention may further include a module case 400, which has both ends opened and in which the pouch cell assembly 100 and the busbar frame assembly 200 are accommodated, and an end plate 500 which covers each of both the opened ends of the module case 400.

The module case 400 (or mono-frame) may serve as an enclosure that maintains a shape of the secondary battery module 10 and protects the pouch cell assembly 100, the flexible printed circuit board 300, and the busbar frame assembly 200 that are accommodated therein. The module case 400 may have a shape in which the both ends are opened, and the pouch cell assembly 100 may be inserted through the both ends.

In addition, the secondary battery module 10 according to the present invention may further include a connector 600 that transmits a signal output from the flexible printed circuit board 300 to an external battery management system (BMS) . Here, the signal output from the flexible printed circuit board 300 may be a signal obtained by sensing the cell voltage transmitted from the busbar 210, the temperature inside the module, or whether the electrolyte leaks as described above. In particular, in the secondary battery module 10 according to the present invention, the sensing part 320 may sense whether the first exposed portion 321a and the second exposed portion 322a are electrically connected to each other by the moisture or electrolyte, and the connector 600 may transmit the result of the sensing to a micro controller unit (MCU) of the BMS to detect whether the electrolyte leaks.

### Embodiment 2

Embodiment 2 of the present invention is different from Embodiment 1 in that the terrace part 223 of the fixing plate 220 according to Embodiment 1 includes a first inclined part 223a and a second inclined part 223b. Thus, the other components of the secondary battery module 10 may be understood as the same as those described in Embodiment 1 and illustrated in FIGS. 3 to 6b, and also resultant effects may be expected to be the same.

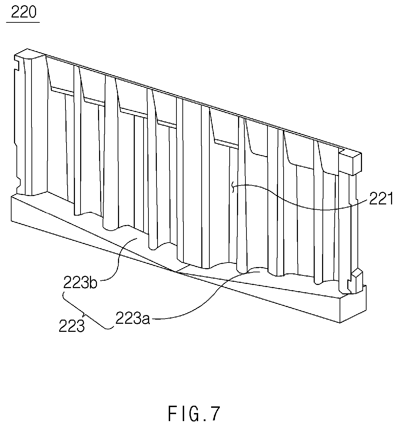

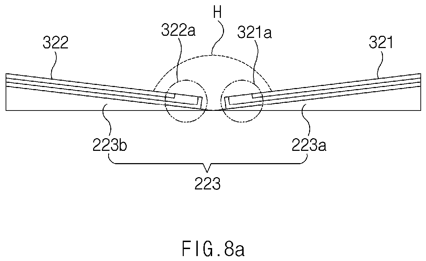

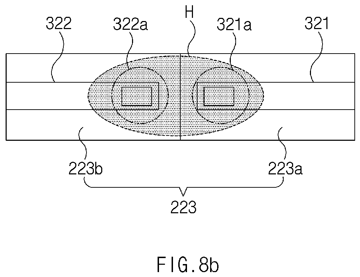

FIG. 7 is a perspective view illustrating a fixing plate of a secondary battery module according to Embodiment 2 of the present invention. FIG. 8a is a side view illustrating a first extension line part, a second extension line part, and a terrace part of the secondary battery module according to Embodiment 2 of the present invention when viewed from a side. FIG. 8b is a plan view illustrating the first extension line part, the second extension line part, and the terrace part of the secondary battery module according to Embodiment 2 of the present invention when viewed from above.

Referring to FIG. 7, a terrace part 223 of a fixing plate 220 according to Embodiment 2 of the present invention includes the first inclined part 223a having a height that gradually decreases from one side to a center, and the second inclined part 223b having a height that gradually decreases from the other side to the center. In addition, as illustrated in FIGS. 8a and 8b, a first exposed portion 321a is disposed on a top surface of the first inclined part 223a, and a second exposed portion 322a is disposed on a top surface of the second inclined part 223b.

Here, each of the first inclined part 223a and the second inclined part 223b may be a flat surface but is not necessarily limited thereto. Each of the first inclined part 223a and the second inclined part 223b may be provided as a curved surface. For example, each of the first inclined part 223a and the second inclined part 223b may have various shapes as long as the first inclined part 223a is provided to have the height that gradually decreases from the one side to the center of the terrace part 223 and the second inclined part 223b is provided to have the height that gradually decreases from the other side to the center thereof as described above, so that the first inclined part 223a and the second inclined part 223b are connected to each other in a state of being in contact with each other, and the terrace part 223 has a central portion that is recessed when viewed from a side.

As the secondary battery module 10 according to Embodiment 2 of the present invention includes the first inclined part 223a and the second inclined part 223b as above, even when a small amount of the electrolyte leaks, the electrolyte is collected between the first inclined part 223a and the second inclined part 223b of the terrace part 223, each of which is provided to be concave as the height gradually decreases toward the center. The electrolyte may be detected from the first exposed portion 321a and the second exposed portion 322a and thus, leakage or submergence detectability may be improved.

### Embodiment 3

Embodiment 3 of the present invention is different from Embodiments 1 and 2 in that Embodiment 3 is a flexible printed circuit board 300 included in the secondary battery module 10 according to each of Embodiments 1 and 2. Thus, the detailed configuration and effects of the flexible printed circuit board 300 described below may be understood as the same as those described in Embodiments 1 and 2 and illustrated in FIGS. 3 to 8b.

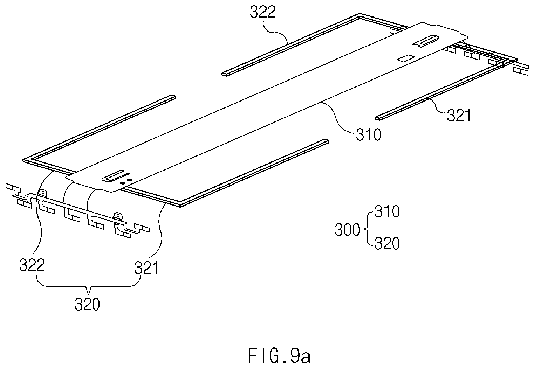

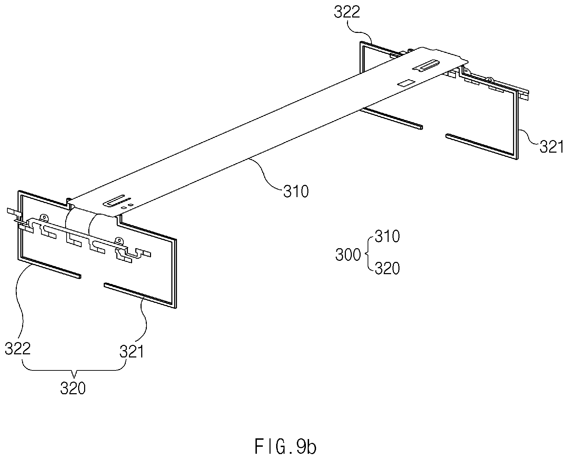

FIG. 9a is a perspective view illustrating the flexible printed circuit board 300 according to Embodiment 3 of the present invention. FIG. 9b is a perspective view illustrating a state in which a first extension line part and a second extension line part are bent in the flexible printed circuit board 300 according to Embodiment 3 of the present invention.

Referring to FIGS. 9a and 9b, the flexible printed circuit board 300 according to Embodiment 3 of the present invention is the flexible printed circuit board (FPCB) 300 in which a film layer is stacked on at least one surface of a metal layer. The flexible printed circuit board 300 includes a body part 310 and a sensing part 320 that extends from the body part 310 and is provided at each of one side and the other side in a width direction of the body part 310 to sense leakage of moisture or an electrolyte, at least one of one side or the other side in a longitudinal direction of the body part 310.

In addition, the sensing part 320 may include a first extension line part 321, which extends toward one side in the width direction of the body part 310, and a second extension line part 322 which extends toward the other side in the width direction of body part 310.

In the flexible printed circuit board 300 according to Embodiment 3 of the present invention, the first extension line part 321 extends toward the one side in the width direction of the body part 310 and may have an area of at least a portion including an end, which is provided to be parallel to the longitudinal direction of the body part 310, and the second extension line part 322 extends toward the other side in the width direction of body part 310 and may have an area of at least a portion including an end, which is provided to be parallel to the longitudinal direction of the body part 310.

As above, each of the first extension line part 321 and the second extension line part 322 may extend integrally from the body part 310 of the flexible printed circuit board 300. For example, the body part 310 and each of the first extension line part 321 and the second extension line part 322 may be provided by cutting the sheet-shaped flexible printed circuit board 300. Thus, when the cutting is performed so that the first extension line part 321 is provided to have the area of at least a portion including the end, which is parallel to the longitudinal direction of the body part 310, and the second extension line part 322 is provided to have the area of at least a portion including the end, which is parallel to the longitudinal direction of the body part 310, the cutting area of the sheet-shaped flexible printed circuit board 300 may be minimized. Accordingly, yield of products may be maximized to reduce the costs.

Each of the first extension line part 321 and the second extension line part 322 may be provided to be bendable. As each of the first extension line part 321 and the second extension line part 322 is provided to be bendable as above, the total volume occupied by the sensing part 320 of the flexible printed circuit board 300 during the bending may be minimized, and the sensing part 320 may be mounted in devices or frames having various shapes with an occupied space minimized. In particular, the sensing part 320 may be mounted in the module as described in Embodiment 1 to maximize the energy density.

In addition, the first extension line part 321 may have an end having a first exposed portion 321a at which the metal layer is exposed, and the second extension line part 322 may have an end having a second exposed portion 322a at which the metal layer is exposed.

Here, the respective ends of the first extension line part 321 and the second extension line part 322 may be bent to face each other in a state of being spaced a predetermined gap from each other. In more detail, as the first extension line part 321 and the second extension line part 322 are bent, the first exposed portion 321a and the second exposed portion 322a may be bent to face each other in a state of being spaced a predetermined gap from each other.

The sensing part 320 according to Embodiment 3 of the present invention may sense whether the first exposed portion 321a and the second exposed portion 322a are electrically connected to each other by moisture or electrolyte. That is, when the first exposed portion 321a and the second exposed portion 322a are submerged together by the moisture or electrolyte, the first exposed portion 321a and the second exposed portion 322a may be electrically connected to each other and accordingly, the electrolyte leakage or submergence may be sensed.

Although the present invention has been described with reference to the limited embodiments and drawings, the present invention is not limited thereto and may be variously implemented by those of ordinary skill in the art to which the present invention pertains, within the technical idea of the present invention and an equivalent of the appended claims.

### [Description of the Symbols]

10: Secondary battery module
100: Pouch cell assembly
200: Busbar frame assembly
210: Busbar
220: Fixing plate
221: Lead insertion part
222: Busbar seating part
223: Terrace part
223a: First inclined part
223b: Second inclined part
230: Cover plate
300: Flexible printed circuit board
310: Body part
320: Sensing part
321: First extension line part
321a: First exposed portion
322: Second extension line part
322a: Second exposed portion
400: Module case
500: End plate
600: Connector
H: Electrolyte or moisture

## Claims

1. A secondary battery module comprising:
a pouch cell assembly in which a plurality of pouch cells are arranged in a thickness direction;
a busbar frame assembly coupled to each of one side and the other side of the pouch cell assembly; and
a flexible printed circuit board (FPCB) which is coupled to the busbar frame assembly and in which a film layer is stacked on at least one surface of a metal layer,
wherein the flexible printed circuit board comprises:
a body part provided between the busbar frame assemblies coupled to the one side and the other side of the pouch cell assembly, respectively; and
a sensing part extending from the body part, wherein the sensing part extends from at least one of one side or the other side in a longitudinal direction of the body part, and provided at each of one side and the other side in a width direction of the body part to sense leakage of moisture or an electrolyte.

2. The secondary battery module of claim 1, wherein the sensing part comprises:
a first extension line part extending toward the one side in the width direction of the body part; and
a second extension line part extending toward the other side in the width direction of the body part.

3. The secondary battery module of claim 2, wherein each of the first extension line part and the second extension line part is bent along a circumference of the busbar frame assembly.

4. The secondary battery module of claim 3, wherein the first extension line part and the second extension line part have ends, respectively, which are bent to face each other in a state of being spaced a predetermined gap from each other.

5. The secondary battery module of claim 3, wherein the first extension line part has an end having a first exposed portion at which the metal layer is exposed, and
the second extension line part has an end having a second exposed portion at which the metal layer is exposed.

6. The secondary battery module of claim 5, wherein the sensing part senses whether the first exposed portion and the second exposed portion are electrically connected to each other by the moisture or electrolyte.

7. The secondary battery module of claim 5, wherein the busbar frame assembly comprises:
a busbar electrically coupled to an electrode lead of the pouch assembly; and
a fixing plate in which a lead insertion part having a slit having a shape passing through front and rear surfaces so that the electrode lead is inserted thereinto, a busbar seating part provided at one side of the lead insertion part, and a terrace part extending from a lower portion of the lead insertion part to a side of the pouch cell assembly, are provided,
wherein the first exposed portion and the second exposed portion are disposed on a top surface of the terrace part.

8. The secondary battery module of claim 7, wherein the busbar frame assembly further comprises a cover plate configured to cover the busbar and coupled to the fixing plate.

9. The secondary battery module of claim 1, further comprising:
a module case which has both ends opened and in which the pouch cell assembly and the busbar frame assembly are accommodated; and
an end plate configured to cover each of both the opened ends of the module case.

10. The secondary battery module of claim 1, further comprising a connector configured to transmit a signal output from the flexible printed circuit board to an external battery management system (BMS).

11. The secondary battery module of claim 7, wherein the terrace part comprises:
a first inclined part having a height that gradually decreases from one side to a center; and
a second inclined part having a height that gradually decreases from the other side to the center,
wherein the first exposed portion is disposed on a top surface of the first inclined part, and the second exposed portion is disposed on a top surface of the second inclined part.

12. A flexible printed circuit board (FPCB) in which a film layer is stacked on at least one surface of a metal layer, the flexible printed circuit board comprising:
a body part; and
a sensing part extending from the body part and provided at each of one side and the other side in a width direction of the body part to sense leakage of moisture or an electrolyte, at least one of one side or the other side in a longitudinal direction of the body part.

13. The flexible printed circuit board of claim 12, wherein the sensing part comprises:
a first extension line part extending toward the one side in the width direction of the body part; and
a second extension line part extending toward the other side in the width direction of the body part.

14. The flexible printed circuit board of claim 13, wherein the first extension line part extends toward the one side in the width direction of the body part and has an area of at least a portion comprising an end, which is provided to be parallel to the longitudinal direction of the body part, and
the second extension line part extends toward the other side in the width direction of body part and has an area of at least a portion comprising an end, which is provided to be parallel to the longitudinal direction of the body part.

15. The flexible printed circuit board of claim 13, wherein each of the first extension line part and the second extension line part is provided to be bendable.

16. The flexible printed circuit board of claim 13, wherein the first extension line part has an end having a first exposed portion at which the metal layer is exposed, and
the second extension line part has an end having a second exposed portion at which the metal layer is exposed.

17. The flexible printed circuit board of claim 16, wherein the sensing part senses whether the first exposed portion and the second exposed portion are electrically connected to each other by the moisture or electrolyte.
